# EUROPEAN PATENT APPLICATION

(11) **EP 2 645 434 A1**
(43) Date of publication of application: **02.10.2013**
(21) Application number: 12162424.1
(22) Date of filing: 30.03.2012
(51) Int. Cl.: H01L 33/58

(54) **Led-packaging arrangement with uniform light and wide angle**

(71) Applicant: Lumenmax Optoelectronics Co., Ltd., 32063 Zhongli City, Taoyuan County (TW)
(72) Inventor: Hsieh, Chia-Han, 32063 ZhongLi City, Taoyuan County (TW); Chen, Lerry, 32063 ZhongLi City, Taoyuan County (TW)
(74) Representative: Chaillot, Geneviève

(57) **Abstract**

A LED-packaging arrangement with uniform light and wide angle includes: a substrate (31), a reflector cup (35) molded upon the substrate (31), a light-emitting diode (32) mounted on the substrate (31) and located inside the reflector cup (35), an encapsulation body (33) molded inside the reflector cup (35) and covering the light-emitting diode (32), and a wide-angle lens (36) molded directly on the top surface of the reflector cup (35) and the encapsulation body (33) to form a wide-angle light distribution and an uniform light emitting. Whereby, the present invention substantially reduces an optical attenuation to overcome the optical attenuation problem of the prior art, and avoids an alignment and combination problems of the conventional secondary packaging.

## Description

### BACKGROUND OF THE INVENTION

### 1. Field of the Invention:

The present invention relates to a LED-packaging arrangement with uniform light and wide angle and more particularly, to a wide-angle lens in a type of batwing, which directly being molded by a primary optics design.

### 2. Description of the Related Art:

Light-emitting diode (LED) technology has become more and more mature. It has been widely used in the indicators and display devices of the information, communications and consumer electronics products in our life. Besides, people use a packaging structure of the light-emitting diode to obtain electricity, light and heat. Therefore, the optical design is important for the packaging structure and how to effectively emit the light from the LEDs, and the light-emitting angle and direction are the key points of the design. Without a particular optics design on the light-emitting diode packaging structure, there will be about 120° of light-emitting angle. Moreover, without a particular optics design, the light-emitting diode must maintain the high arrangement density for the array of light-emitting diode to be set to become a surface light source. Another light-emitting diode with a particular optics design has more than 120° light-emitting angle, which can be set less the amount of light emitting diodes to achieve the same illustration area.

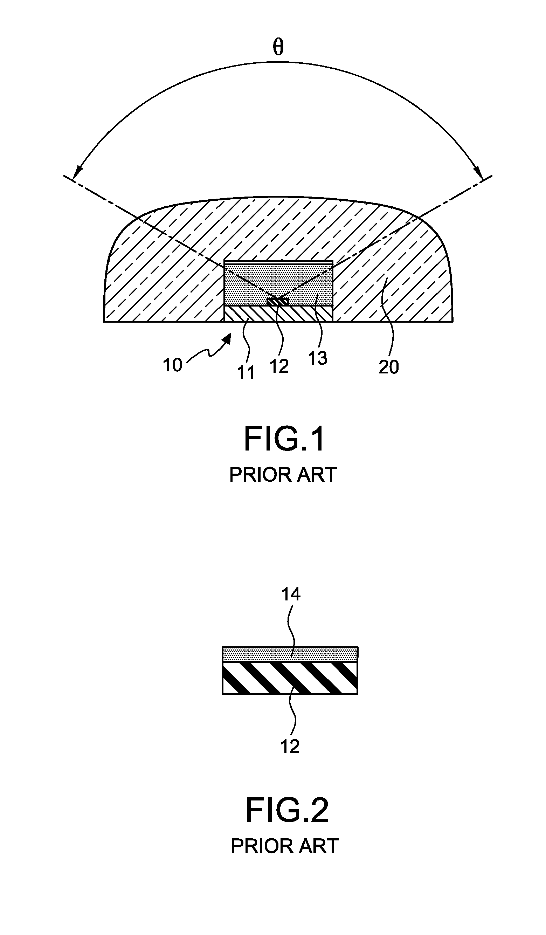

With reference to FIG. 1, a light-emitting diode packaging structure **10** includes a substrate **11,** a light-emitting diode **12,** an encapsulation body **13,** and a wide-angle lens 20 mounted on the surface thereof in order to enlarge the light-emitting angle from the original 120° to larger light-emitting angle θ. However, due to the secondary optics design of the wide-angle lens, there will be 80% to 85% of an optical attenuation. Also, there are combination and alignment problems when mounting the wide-angle lens on the light-emitting diode.

The first kind of light color from the light-emitting diode mixes with the second kind of light color from a phosphor powder with different lusters, forming the third kind of light color. This kind of light mixing application is very common. For example, the blue light from the light-emitting diode mixes with the yellow light from the yttrium aluminum garnet yellow phosphor powder, forming the white light. According to the common production method, a phosphor layer **14** as shown in FIG. 2 is formed on the surface of the light-emitting diode **12** by the spray coating technology. However, the thickness of the phosphor layer **14** is hard to control, resulting in the irregular phosphor layer **14** and non-uniform color temperature.

### SUMMARY OF THE INVENTION

It is a primary object of the present invention is to provide a LED-packaging arrangement with uniform light and wide angle, which substantially reduces optical attenuation to overcome the optical attenuation problem of the prior art.

The second object of the present invention is to provide a LED-packaging arrangement with uniform light and wide angle, which avoids the combination and alignment problems of the secondary packaging.

The third object of the present invention is to provide a LED-packaging arrangement with uniform light and wide angle, which enables the phosphor layer to be formed with regularity.

The last object of the present invention is to provide a LED-packaging arrangement with uniform light and wide angle, which forms the micro-structure in nature.

In order to achieve the above-mentioned objects, the invention includes: a substrate, a reflector cup molded upon the substrate, a light-emitting diode mounted on the substrate and located inside the reflector cup, an encapsulation body molded inside the reflector cup and covering the light-emitting diode, and a wide-angle lens molded directly on the top surface of the reflector cup and the encapsulation body to form a wide-angle light distribution and an uniform light emitting.

Further, the reflector cup may have a cup depth being in a range of 0.20 ∼0.50 mm. The wide-angle lens may include a concave portion at a center area thereof to form a shape of batwing and may cover a top surface of the reflector cup and the encapsulation body. The wide-angle lens may be a type of symmetric circular body, and a size proportion of a circular symmetrical wide-angle lens includes: an outermost peripheral radius of the circular symmetrical wide-angle lens is 1.1∼2.5 times the length of a highest point radius of the circular symmetrical wide-angle lens; the highest point of the circular symmetrical wide-angle lens is 4.5∼9.5 times the height of a central lowest point of the circular symmetrical wide-angle lens. The wide-angle lens also can be a type of non-circular symmetric body, and a size proportion of a non-circular symmetrical wide-angle lens includes: a highest point of the non-circular symmetrical wide-angle lens is 1.02∼1.20 times the height of a central concave point of the non-circular symmetrical wide-angle lens; the highest point of the non-circular symmetrical wide-angle lens is 2.5∼6.5 times the height of a curved lowest point of the non-circular symmetrical wide-angle lens.

Further, the light-emitting diode may include a phosphor layer on a top surface thereof, the phosphor layer is composed of a plurality of micro-colloid particles containing phosphor powder therein and being formed by a dispensing technology, and each of the micro-colloid particles is arranged in accordance with a predetermined rule. A diameter of the micro-colloid particle may be in a range of 0.05∼0.20mm; a particle diameter of phosphor powder in the micro-colloid particle may be in a range of 3∼15um; a thickness of the phosphor layer may be in a range of 20∼50um.

### BRIEF DESCRIPTION OF THE DRAWINGS

FIG 1 is a schematic diagram of a conventional light-emitting diode packaging structure with a wide-angle design;
FIG 2 is a schematic diagram of a common phosphor layer on the light-emitting diode;
FIG 3 is a schematic diagram of the present invention applied to a circular symmetric packaging;
FIG 4 is a schematic diagram of the present invention applied to a non-circular symmetric packaging;
FIG 5 is a cross-sectional view taken along the line 5-5 in FIG 4;
FIG 6 is a schematic diagram of the phosphor layer in accordance with the present invention; and
FIG 7 is a cross-sectional view taken along the line 7-7 in FIG 6;

### DETAILED DESCRIPTION OF THE PREFERRED EMBODIMENT

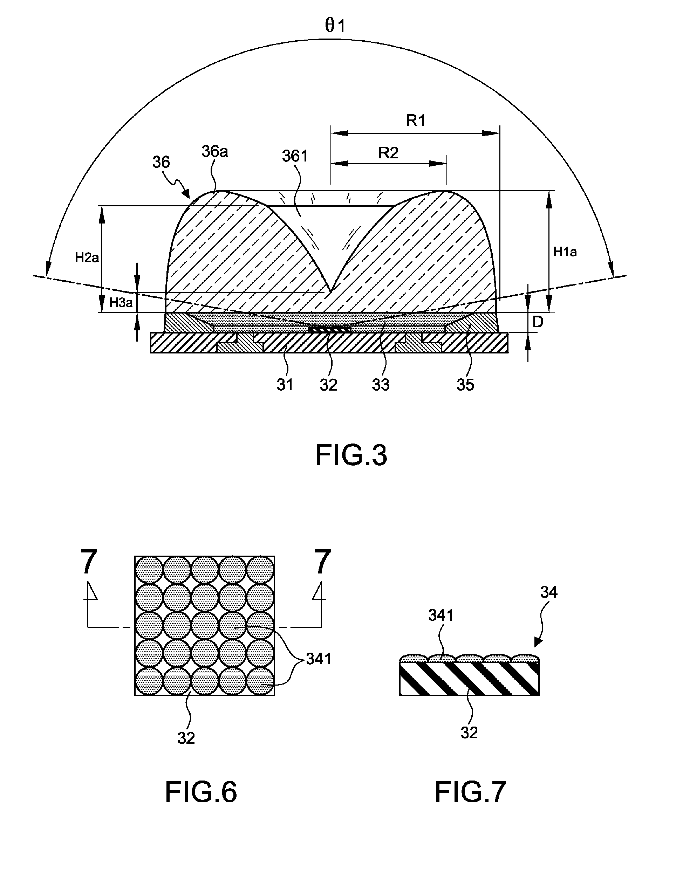

With reference to FIG 3, the first embodiment of the present invention applied to a circular symmetric packaging comprises: a substrate **31,** a reflector cup **35** molded upon the substrate **31** and having a cup depth **D** being in a range of 0.20∼0.50 mm, a light-emitting diode **32** mounted on the substrate **31** and located inside the reflector cup **35,** an encapsulation body **33** molded inside the reflector cup **35** and covering the light-emitting diode **32;** and a wide-angle lens **36.** In this embodiment, a circular symmetrical wide-angle lens **36a** includes a circular bottom surface and a concave portion **361** at a center area thereof to be in a type of batwing, and is molded directly on the top surface of the reflector cup **35** and the encapsulation body **33.** A curve of the concave portion **361** is composed of two curves with different curvature in order to form a height of highest point **H1a** and a height of a second highest point **H2**a. Further, the circular symmetrical wide-angle lens **36a** covers a top surface of the reflector cup **35** and the encapsulation body **33** to form a wide-angle light distribution and a uniform light emitting. Further, the size proportion of the circular symmetrical wide-angle lens **36a** includes: an outermost peripheral radius **R1** of the circular symmetrical wide-angle lens **36a** is 1.1∼2.5 times the length of a highest point radius **R2** of the circular symmetrical wide-angle lens **36a;** the highest point **H1a** of the circular symmetrical wide-angle lens **36a** is 1.05∼1.25 times the height of the second highest point **H2a** of the circular symmetrical wide-angle lens **36a;** the highest point **H1a** of the circular symmetrical wide-angle lens **36a** is 4.5∼9.5 times the height of a lowest point **H3a** of the circular symmetrical wide-angle lens **36a.**

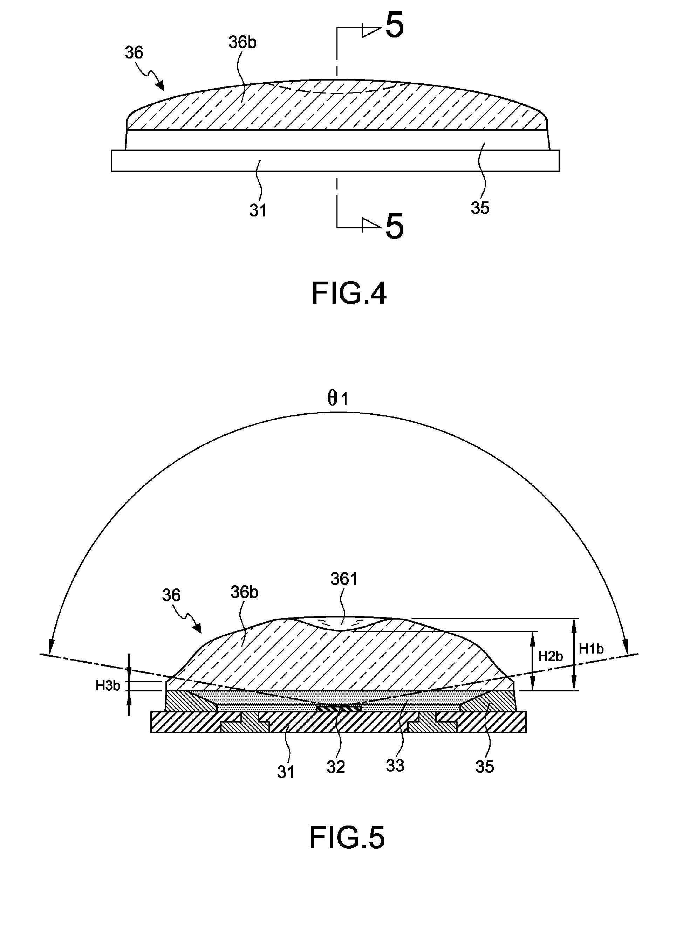

With reference to FIGS. 4 and 5, the second embodiment of the present invention is applied to a non-circular symmetric packaging. The difference between the circular symmetric packaging embodiment and the non-circular symmetric packaging embodiment is the size proportion of the wide-angle lens **36.** The size proportion of a non-circular symmetrical wide-angle lens **36b** includes: the highest point **H1b** of the non-circular symmetrical wide-angle lens **36b** is 1.05∼1.20 times the height of a central concave point **H2b** of the non-circular symmetrical wide-angle lens **36b;** the highest point **H1b** of the non-circular symmetrical wide-angle lens **36b** is 2.5∼6.5 times the height of a curved lowest point **H3b** of the non-circular symmetrical wide-angle lens **36b.** In this embodiment, the non-circular symmetrical wide-angle lens **36b** includes long body such as a rectangular body and an elliptic body.

With reference to FIGS. 6 and 7, the light-emitting diode **32** further includes a phosphor layer **34** on a top surface thereof, the phosphor layer **34** is composed of a plurality of micro-colloid particles **341** containing phosphor powder therein and being formed by a dispensing technology, and each of the micro-colloid particles **341** is arranged in accordance with a predetermined rule; wherein a diameter of the micro-colloid particle **341** is in a range of 0.05∼0.20mm; a particle diameter of phosphor powder in the micro-colloid particle **341** is in a range of 3∼15um; a thickness of the phosphor layer **34** is in a range of 20∼50um.

Based on the technical features disclosed, the present invention enables the wide-angle lens **36** with the batwing type to be molded directly on the top surface of the reflector cup **35** and the encapsulation body **33** by a primary optics design. That is, the wide-angle lens **36** is molded directly on the top surface of the reflector cup **35** and the encapsulation body **33** and forms a batwing shape by a primary processing method. Compared to the conventional secondary optics design of a wide-angle optical lens, which uses a secondary processing method to fix the wide-angle optical lens, the present invention has an effect on substantially reducing the optical attenuation. Moreover, the primary optics design allows the present invention to form the wide-angle distribution and uniform light emitting; that is, when the light from the light-emitting diode **32** is reflected and refracted through the top surface of the wide-angle lens **36** by the light-emitting surface design of the batwing type, the light-emitting angle (θ1) is in 160° wide-angle distribution. The primary optics design of the present invention also avoids an alignment and combination problems of the secondary packaging.

Due to the small amount of the dispensing, each of the micro-colloid particles **341** can be formed in accordance with the predetermined shape, resulting in the regular thickness and uniformity of the phosphor powder **34.** Therefore, the present invention can regularly form the phosphor layer and naturally form a micro-structure.

Although particular embodiments of the invention have been described in detail for purposes of illustration, various modifications and enhancements may be made without departing from the spirit and scope of the invention. Accordingly, the invention is not to be limited except as by the appended claims.

## Claims

1. A LED-packaging arrangement with uniform light and wide angle, comprising:
a substrate (31);
a reflector cup (35) molded upon said substrate (31);
a light-emitting diode (32) mounted on said substrate (31) and located inside said reflector cup (35);
an encapsulation body (33) molded inside said reflector cup (35) and covering said light-emitting diode (32); and
a wide-angle lens (36) molded directly at the top surface of said reflector cup (35) and said encapsulation body (33) to form a wide-angle light distribution and an uniform light emitting.

2. The LED-packaging arrangement with uniform light and wide-angle as claimed in claim 1, wherein said reflector cup (35) has a cup depth (D) being in a range of 0.20∼0.50 mm.

3. The LED-packaging arrangement with uniform light and wide-angle as claimed in claim 2, wherein said wide-angle lens (36) includes a concave portion (361) at a center area thereof to form a shape of batwing.

4. The LED-packaging arrangement with uniform light and wide-angle as claimed in claim 3, wherein said wide-angle lens (36) covers a top surface of said reflector cup (35) and said encapsulation body (33).

5. The LED-packaging arrangement with uniform light and wide-angle as claimed in claim 4, wherein said wide-angle lens (36) is a type of symmetric circular body, and a size proportion of a circular symmetrical wide-angle lens (36a) includes: an outermost peripheral radius (R1) of said circular symmetrical wide-angle lens (36a) is 1.1∼2.5 times the length of a highest point radius (R2) of said circular symmetrical wide-angle lens (36a); a highest point (H1a) of said circular symmetrical wide-angle lens (36a) is 1.05∼1.25 times the height of a second highest point (H2a) of said circular symmetrical wide-angle lens (36a); said highest point of (H1a) said circular symmetrical wide-angle lens (36a) is 4.5∼9.5 times the height of a central lowest point (H3a) of said circular symmetrical wide-angle lens (36a).

6. The LED-packaging arrangement with uniform light and wide angle as claimed in claim 4, wherein said wide-angle lens (36) is a type of non-circular symmetric body such as a rectangular body and an elliptic body, and a size proportion of a non-circular symmetrical wide-angle lens (36b) includes: a highest point (H1b) of said non-circular symmetrical wide-angle lens (36b) is 1.02∼1.20 times the height of a central concave point (H2b) of said non-circular symmetrical wide-angle lens (36b); said highest point (H1b) of said non-circular symmetrical wide-angle lens (36b) is 2.5∼6.5 times the height of a curved lowest point (H3b) of said non-circular symmetrical wide-angle lens (36b).

7. The LED-packaging arrangement with uniform light and wide angle as claimed in any one of claims 5 and 6, wherein said light-emitting diode (32) includes a phosphor layer (34) on a top surface thereof, said phosphor layer (34) is composed of a plurality of micro-colloid particles (341) containing phosphor powder therein and being formed by a dispensing technology, and each of said micro-colloid particles (341) is arranged in accordance with a predetermined rule.

8. The LED-packaging arrangement with uniform light and wide angle as claimed in claim 7, wherein a diameter of said micro-colloid particle (341) is in a range of 0.05∼0.20mm; a particle diameter of phosphor powder in said micro-colloid particle (341) is in a range of 3∼15um; a thickness of said phosphor layer (34) is in a range of 20∼50um.
